# EUROPEAN PATENT APPLICATION

(11) **EP 3 109 908 A2**
(43) Date of publication of application: **28.12.2016**
(21) Application number: 16176228.1
(22) Date of filing: 24.06.2016
(51) Int. Cl.: H01L 33/50, H01L 33/60, H01L 33/62

(54) **LIGHT EMITTING DEVICE AND MANUFACTURING METHOD THEREOF**

(30) Priority: 26.06.2015 TW 104120755; 28.08.2015 US 201562211002 P; 30.10.2015 US 201562248313 P
(71) Applicant: Everlight Electronics Co., Ltd, New Taipei City 23860 (TW)
(72) Inventor: Lin, Chih-Min, 23860 New Taipei City (TW); Lu, Tsung-Lin, 23860 New Taipei City (TW); Lai, Jen-Hsiung, 23860 New Taipei City (TW); Yeh, Robert, 23860 New Taipei City (TW); Hung, I-Chun, 23860 New Taipei City (TW); Yu, Wei-Tyng, 23860 New Taipei City (TW); Lu, Kuang-Mao, 23860 New Taipei City (TW); Liu, Ru-Shi, 23860 New Taipei City (TW)
(74) Representative: Becker Kurig Straus

(57) **Abstract**

A light emitting device includes a substrate; an LED chip, disposed on the substrate; and a fluorescent layer. The fluorescent layer is at least partially and conformally coated on the LED chip and the substrate.

## Description

### BACKGROUND OF THE INVENTION

### 1. Technical Field

The present invention relates to a light emitting device having an LED chip.

### 2. Description of Related Art

In the relevant art, according to industrial practices, a fluorescent material is generally disposed on LED chip by means of dispensing, molding, spray coating and so on. However, these conventional methods have problems concerning process control and costs due to their processing properties. For example, dispensing tends to see precipitation of the fluorescent material that in turn brings about the yellow-halo problem, leading to inconsistent color temperature and a wide range of bins. Molding has distribution of the fluorescent material vary with distribution of pressure, and also tends to have inconsistent color temperature and a wide range of bins. Spray coating, on the other hand, is less subject to problems related to inconsistent color temperature and a wide range of bins, but the process requires repeated spray coating and tests, making it a time-consuming and low-material-utilization approach.

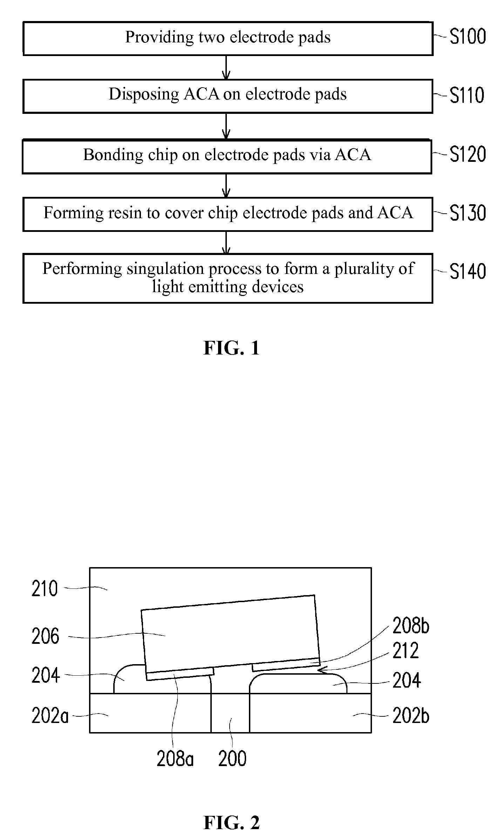

In addition, anisotropic conductive adhesive (ACA) is also used in the industry for binding before molding is performed to install a translucent layer. Such an approach is as illustrated in detail in FIG. 1. In the resultant product, electrodes 208a, 208b of the chip 206 are bound to electrode pads 202a, 202b in the substrate 200 by means of anisotropic conductive adhesive (ACA) 204. Nevertheless, in the molding process (Step S130), there is a certain chance that the resin 210 forming the translucent layer passes through the anisotropic conductive adhesive (ACA) 204 and separates the chip 206 from the electrode pad 202b (as indicated by the region 212 in FIG. 2), endangering the overall reliability and even causing the whole product to fail.

### SUMMARY OF THE INVENTION

In view of this, the present invention provides a novel packaging scheme for addressing the problems related to traditional application of fluorescent material. A light emitting device of the present invention comprises: a substrate; an LED chip, disposed on the substrate; and a fluorescent layer, the fluorescent layer being at least partially and conformally coated on the LED chip and the substrate. In a variant example of the foregoing light emitting device, the light emitting device further comprises a reflective portion, surrounding the LED chip and/or the fluorescent layer. In another variant example of the foregoing light emitting device, the light emitting device comprises a translucent layer coated on the fluorescent layer.

Particularly, the present invention uses semi-cured fluorescent resin to form the fluorescent layer, and this approach has at least the following advantages:
A. The semi-cured fluorescent resin helps to control distribution of the fluorescent material, keeping the manufacturing cost low and allowing quick processing of light emitting devices.
B. With the use of semi-cured fluorescent resin, the thickness of plastic sheet can be controlled effectively, thereby reducing the problems related to inconsistent color temperature and wide bin range.
C. The semi-cured fluorescent resin protects the LED chip and the die bonding area from external force and foreign matters that cause the chip to come off or get damaged.
D. It is applicable to a molding process using ACA. In this case the semi-cured fluorescent resin protects the chip and the electrode pads by preventing the resin of the translucent layer from passing through ACA, and in turn preventing the chip from separating from the electrode pads.
E. It is applicable to a wiring process. In this case the semi-cured fluorescent resin protects the chip and the wires, balls or welding spots from external compression.

With the aforementioned advantages, the disclosed packaging scheme is suitable for various LED devices from and processes for all types of chips, making it of great industrial applicability.

In addition, the disclosed packaging method conformally disposes the fluorescent layer on the LED chip. For preventing the problem that fluorescent material is affected by the external moisture and has the overall reliability degraded, the encapsulation resin suitable has its moisture permeability below 11 g/m²/24Hr and has its oxygen permeability below 400 cm³/m²/24Hr so as to reduce impact of moisture/oxygen on the fluorescent material. By using encapsulation resin with specific physical properties, reliability of the fluorescent material can be effectively improved. Particularly, tetravalent-manganese-activated red fluorescent material is subject to hydrolysis when affected by moisture and has its luminous efficacy and reliability degraded. The red fluorescent material has a chemical formula of A₂[MF₆]:Mn⁴⁺, wherein A is selected from Li, Na, K, Rb, Cs, NH₄ and any combination thereof and M is selected from Ge, Si, Sn, Ti, Zr and any combination thereof. In addition, fluorescent materials of other color may be used for further expanding the color gamut of the resultant light emitting device. Thus, by selecting encapsulation resin that has its moisture permeability and oxygen permeability in the above-indicated ranges, the present invention can solve its potential technical issues.

It is to be noted that in the present invention the encapsulation resin refers to any resin covering the LED chip for packaging the chip. In a lamination process, it may solely refer to a fluorescent layer (where there is no translucent layer), or a combination of a fluorescent layer and a translucent layer (where there is a translucent layer). In a dispensing process, it may refer to dispensing resin. Such dispensing process will be described in detail later.

The invention as well as a preferred mode of use, further objectives and advantages thereof will be best understood by reference to the following detailed description of illustrative examples when read in conjunction with the accompanying drawings.

### BRIEF DESCRIPTION OF THE DRAWINGS

FIG. 1 is a flowchart of a conventional method wherein ACA is used to bind the chip and the electrode pads, and molding is used to applying the translucent layer.
FIG. 2 schematically shows separation between the chip and the electrode pad during the conventional molding process of FIG. 1.
FIG. 3 is a schematic drawing of a light emitting device of the present invention.
FIG. 4 is a flowchart of making semi-cured fluorescent resin according to the present invention.
FIG. 5A through FIG. 5D show a process according to a second embodiment of the present invention.
FIG. 6A through FIG. 6D show continuous batch laminating operation of FIG. 5C.
FIG. 7A through FIG. 7C provide a variant example of the second embodiment.
FIG. 8A and FIG. 8B show another variant example of the second embodiment.
FIG. 9A and FIG. 9B show yet another variant example of the second embodiment.
FIG. 10A through FIG. 10C show still another variant example of the second embodiment.
FIG. 11A and FIG. 11B show still another variant example of the second embodiment.
FIG. 12 is still another variant example of the second embodiment.
FIG. 13A through FIG. 13D show a process according to a third embodiment of the present invention.
FIG. 14A through FIG. 14C provide a variant example of the third embodiment.
FIG. 15A through FIG. 15F present a process according to a fourth embodiment of the present invention.
FIG. 16A through FIG. 16J show various variant examples of the fourth embodiment.
FIG. 17 is a schematic drawing illustrating a packaging experiment according to the present invention.
FIG. 18 depicts a variant example of the packaging experiment of FIG. 17.
FIG. 19 shows emission spectrums of Experimental Example 1 and Comparative Example 1.
FIG. 20 is a spectrogram representing Experimental Example 2 and Experimental Example 3.
FIG. 21 is a chromaticity diagram of Experimental Example 3.

### DETAILED DESCRIPTION OF THE INVENTION

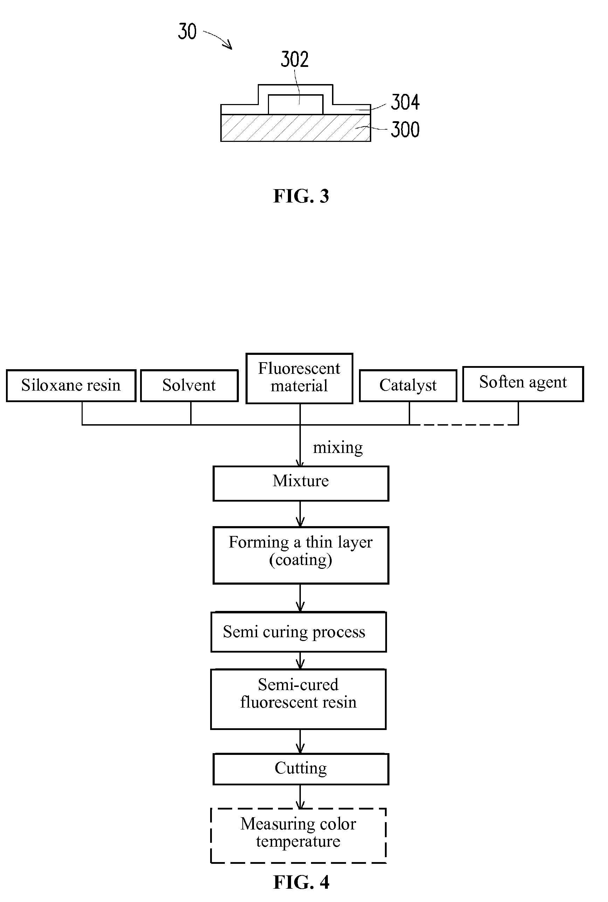

FIG. 3 shows a light emitting device 30 of the present invention, which comprises a substrate 300, an LED chip 302 disposed on substrate 300, and a fluorescent layer 304. The fluorescent layer 304 is at least partially and conformally coated on LED chip 302 and the substrate 300. While some details of the LED chip such as electrodes, substrate electrodes and die bonding material are omitted from FIG. 3, people skilled in the art would understand, by referring to the present invention, that these details are not intended to be limited in the present invention and various embodiments of these components shall be within the scope of the present invention. In addition, the fluorescent layer 304 contains fluorescent material at a concentration that the fluorescent material is distributed evenly across the fluorescent layer 304, so as to prevent inconsistent color temperature. However, distribution of the fluorescent material may be alternatively distributed in an uneven way, such as in a gradient, according to the practical needs.

The components in the disclosed device are now to be described by emphasizing their materials and features.

### <Substrate/Carrier >

In the present invention, a carrier forms substrates after cutting. In the present invention, the substrate/carrier may be a board made of any suitable material, such as a metal leadframe, a printed circuit board, a ceramic board, a glass board, a plastic board and a flexible board. Particularly, where the substrate /carrier is realized by a metal leadframe, it is preferable that the metal leadframe has its internal space filled with a space filler, so as to enhance the overall mechanical strength of the leadframe. Additionally, in some embodiments, the carrier may be removed after a later singulation step, so as to produce a light emitting device without substrate. In this case, the carrier is preferably one with release film on it, so it can be easily removed from the light emitting device when the final singulation step has been done.

### <Chip>

In the present invention, any suitable LED chip may be used. Preferably, the LED chip may be one made of any GaN-based semiconductors, e.g. an InGaN chip. More preferably, the LED chip has a peak wavelength between 450 nm and 460 nm. The LED chip may be one of any of various designs, e.g. a horizontal chip, a vertical chip and a flip chip. It is to be specially noted that both horizontal and vertical chips require a conductive wire for connection with external electrodes. Such conductive wire and other components as well as their assembly will be detailed by means of some embodiments provided later.

### <Fluorescent Material>

Any fluorescent materials that commonly used in the art can be used for the purpose of the present invention. Particularly, the fluorescent material may be one or more selected from the group consisting of: Sr₅(PO₄);Cl:Eu²⁺, (Sr,Ba)MgAl₁₀O₁₇:Eu²⁺, (Sr,Ba)₃MgSi₂O₈:Eu²⁺, SrAl₂O₄:Eu²⁺, SrBaSiO₄:Eu²⁺, CdS:In, CaS:Ce³⁺, Y₃(Al,Gd)₅O₁₂:Ce²⁺, Ca₃Sc₂Si₃O₁₂:Ce³⁺, SrSiON:Eu²⁺, ZnS:Al³⁺,Cu⁺, CaS:Sn²⁺, CaS:Sn²⁺,F, CaSO₄:Ce³⁺,Mn²⁺, LiAlO₂:Mn²⁺, BaMgAl₁₀O₁₇: Eu²⁺,Mn²⁺, ZnS:Cu⁺,Cl⁻, Ca₃WO₆:U, Ca₃SiO₄C₁₂:Eu²⁺, SrₓBa_{y}Cl_{z}Al₂O_{4-z/2}:Ce³⁺,Mn²⁺ (X:0.2, Y:0.7, Z:1.1), Ba₂MgSi₂O₇:Eu²⁺, Ba₂SiO₄:Eu²⁺, Ba₂Li₂Si₂O₇:Eu²⁺, ZnO:S, ZnO:Zn, Ca₂Ba₃(PO₄)₃Cl:Eu²⁺, BaAl₂O₄:Eu²⁺, SrGa₂S₄:Eu²⁺, ZnS:Eu²⁺, Ba₅(PO₄)₃Cl:U, Sr₃WO₆:U, CaGa₂S₄:Eu²⁺, SrSO₄: Eu²⁺,Mn²⁺, ZnS:P, ZnS:P³⁻,Cl⁻, ZnS:Mn²⁺, CaS:Yb²⁺,Cl, Gd₃Ga₄O₁₂:Cr³⁺, CaGa₂S₄:Mn²⁺, Na(Mg,Mn)₂LiSi₄O₁₀F₂:Mn, ZnS:Sn²⁺, Y₃Al₅O₁₂:Cr³⁺, SrBgO₁₃Sm²⁺, MgSr₃Si₂O₈:Eu²⁺,Mn²⁺, α-SrO·3B₂O₃:Sm²⁺, ZnS-CdS, ZnSe:Cu⁺,Cl, ZnGa₂S₄:Mn²⁺, ZnO:Bi³⁺, BaS:Au,K, ZnS:Pb²⁺, ZnS:Sn²⁺,Li⁺, ZnS:Pb,Cu, CaTiO₃:Pr³⁺, CaTiO₃:Eu³⁺, Y₂O₃:Eu³⁺, (Y,Gd)₂O₃:Eu³⁺, CaS:Pb²⁺,Mn²⁺, YPO₄:Eu³⁺, Ca₂MgSi₂O₇:Eu²⁺,Mn²⁺, Y(P,V)O₄:Eu³⁺, Y₂O₂S:Eu³⁺, SrAl₄O₇:Eu³⁺, CaYAlO₄:Eu⁺LaO₂S:Eu³⁺, LiW₂O₈:Eu³⁺,Sm³⁺, (Sr,Ca,Ba,Mg)₁₀(PO₄)₆Cl₂: Eu²⁺,Mn²⁺, Ba₃MgSi₂O₈: Eu²⁺,Mn²⁺, ZnS:Mn²⁺,Te²⁺, Mg₂TiO₄: Mn⁴⁺, K₂SiF₆:Mn⁴⁺, SrS:Eu²⁺, Na_{1.23}K_{0.42}Eu_{0.12}TiSi₄O₁₁, Na_{1.23}K_{0.42}Eu_{0.12}TiSi₅O₁₃:Eu³⁺, CdS:In,Te, CaAlSiN₃:Eu²⁺, CaSiN₃:Eu²⁺, (Ca,Sr)₂Si₅N₈:Eu²⁺, and Eu₂W₂O₇.

Particularly, a red fluorescent material activated by tetravalent manganese may be used in the present invention. Such red fluorescent material has a chemical formula of:

### A₂[MF₆]:Mn⁴⁺

where A is selected from Li, Na, K, Rb, Cs, NH₄ and any combination thereof and M is selected from Ge, Si, Sn, Ti, Zr and any combination thereof.

In the present invention, the red fluorescent material has an average particle size (d50) preferably between 18µm and 41µm. Examples of such red fluorescent material include: K₂SiF₆:Mn⁴⁺, K₂TiF₆:Mn⁴⁺ and K₂GeF₆:Mn⁴⁺ in which K₂SiF₆:Mn⁴⁺ is preferable. These red fluorescent materials when excited by a light source having a peak in a wavelength range between 450nm and 460nm can emit light having a primary peak in a wavelength range between 600nm and 650nm. It is to be noted that the primary peak mentioned herein refers to the wavelength at which point the fluorescent materials reach the greatest luminous intensity thereof. Moreover, the present invention is not limited to use of a single red fluorescent material, and two or more fluorescent materials recited previously can be used together.

For further expanding the color gamut of the light emitting device, it is preferable to use an oxynitride fluorescent material as a green light source. More preferably, the green fluorescent material has a chemical formula selected from the group consisting of:
M^{(II)}₇Al_{12-x-y}Si_{x+y}O₂₅₋ₓN_{x-y}C_{y}:A;
M^{(II)}₇M^{(III)}_{12-x-y}Si_{x+y}O₂₅₋ₓN_{x-y}C_{y}:A; and
M^{(II)}₇M^{(III)}_{12-x-y}Si_{x+y}O_{25-x±3δ/2}N_{x±δ-y}C_{y}:A,
where 0<x≦ 12; 0<y<x; 0<x+y≦ 12; 0<δ≦3; and δ<x+y; M^{(II)} is a bivalent cation selected from the group consisting of: Be, Mg, Ca, Sr, Ba, Cu, Co, Ni, Pd, Zn, Cd and any combination thereof; M^{(III)} is a trivalent cation selected from the group consisting of: B, Al, Ga, In, Sc, Y, La, Gd and any combination thereof; and A is an active center selected from the group consisting of: Ce, Pr, Nd, Sm, Eu, Gd, Tb, Dy, Ho, Er, Tm, Yb, Lu, Mn, Bi, Sb and any combination thereof. In the present invention, the green fluorescent material has an average particle size (d50) preferably between 18µm and 22µm.

Where a red fluorescent material and a green fluorescent material are used together in the present invention, the red fluorescent material and the green fluorescent material have a weight ratio of 1:1∼3:1 because such ratio endows the resultant light emitting device with better color rendering.

### <Fluorescent Layer>

In the present invention, the fluorescent layer is formed by curing and cutting semi-cured fluorescent resin. The semi-cured fluorescent resin referred to herein is a B-stage resin composition. Under this state, the resin composition has good shape-retaining ability, yet is capable of deforming under external force, and it softens when heated and swells when contacting a solvent, without being fully melted or dissolved. Further, in the present invention, the semi-cured fluorescent resin comprises a fluorescent material, a siloxane resin, a catalyst and a solvent. Based on the weight of the fluorescent layer, the weight of the fluorescent material is 10% to 60%; the weight of the siloxane resin is 28% to 89.3%; the weight of the catalyst is 0.1% to 2%; and the weight of the solvent is 0.1% to 2%. Moreover, in the present invention, the semi-cured fluorescent resin may also comprise a softening agent. Preferably, based on the weight of the fluorescent resin, the weight of the softening agent is 0.5% to 8%. Particularly, after the semi-cured fluorescent resin with the foregoing composition undergoes a curing process (e.g. pressing/baking), the solvent evaporates therefrom. At this time, based on the weight of the final fluorescent layer, the weight of the fluorescent material is 10% to 61.2%; the weight of the siloxane resin is 28% to 91.1%; and the weight of the catalyst is 0.1% to 2%. Where a softening agent is used, the weight of the softening agent is 0.5% to 8.2%.

In some embodiments, the fluorescent layer may be made of resin having its moisture permeability below 11 g/m²/24Hr and having its oxygen permeability below 400 cm³/m²/24Hr. Preferably, the resin us such selected that its moisture permeability is below 10.5 g/m²/24Hr, and oxygen permeability is below 382 cm³/m²/24Hr, so as to reduce hydrolysis or degradation of the fluorescent material and in turn improve the overall reliability of the light emitting device. Such selection of the resin improves the reliability of the tetravalent-manganese-activated red fluorescent material significantly.

In the present invention, the term "moisture permeability" refers to measured values obtained using TSY-TH1 Water Vapor Permeability Tester, and the term "oxygen permeability" refers to measured values obtained using i-Oxtra 7600 Oxygen Permeation Analyzer.

### <Reflective Portion>

The present invention may further comprise a reflective portion. The reflective portion is formed by curing and cutting reflective resin. Particularly, the reflective resin is a resin composition containing reflective particles. The reflective particles contribute to high light convergence and may be selected form TiO₂, SiO₂, ZrO, MgO, BaSO₄ and any combination thereof, in which TiO₂ is preferable. The resin may be epoxide-based resin or siloxane-based resin, in which siloxane-based resin is preferable.

### <Translucent Layer>

In the present invention, the translucent layer is made by curing and cutting translucent resin and may comprise light-diffusing particles for further enhanced uniformity of light. The light-diffusing particles may be selected from BN, SiO₂ and the combination thereof. Additionally, in some embodiments of the present invention, the translucent layer and the semi-cured fluorescent resin have the same basic resin and are formed into translucent layers through similar processes, with the only difference relying on addition of the fluorescent material. In this case, the translucent layer is also conformal, and the cured translucent layer serves to protect the fluorescent layer by preventing moisture from entering the fluorescent layer, so as to improve endurance of the light emitting device. However, in some embodiments, the translucent layer has its moisture permeability and oxygen permeability preferably lower than those of the fluorescent layer, making it more protective. Particularly, in some embodiments, the translucent layer is made of resin having its moisture permeability below 11 g/m²/24Hr and having its oxygen permeability below 400 cm³/m²/24Hr. Preferably, the resin has its moisture permeability below 10.5 g/m²/24Hr, and has its oxygen permeability below 382 cm³/m²/24Hr.

A first embodiment is herein described in detail to illustrate the fluorescent layer of the present invention in regards of process and characteristic.

### «First Embodiment»

The method of the present invention and characteristics and other parameters of the semi-cured fluorescent resin are herein described in detail with reference to FIG. 4. First, a siloxane resin, a fluorescent material, a catalyst, a solvent and optionally a softening agent are mixed to form a mixture with the contents of the components as defined previously. In the present invention, the solvent may be any organic solvent that can be melting blended/mixed with the foregoing materials, preferably toluene. The fluorescent material is selected as described above. The present invention has no limitation to the method of mixing, as long as the practice makes the fluorescent material, the catalyst, the solvent and the optional softening agent well mixed. In the embodiments mentioned below, a vacuum deaearation mixer is used as an example.

The mixture such made is then applied to a plane to form a thin layer. Again, the present invention has no limitation to the method of applying, and the method may be rotary coating, spin coating, knife coating, and dipping coating. In addition, for controlling the thickness of the final semi-cured fluorescent resin within a preferable range between 45µm and 230µm, the thin layer is such made that its thickness is 50µm to 250µm, more preferably 70µm to 185µm. In the examples mentioned below, knife coating is used for forming the thin layer as an example. When the thickness is below 45µm, the fluorescent resin tends to have weakened strength, and the fluorescent material tends to have uneven distribution and in turn poor color uniformity. On the other hand, a thickness greater than 250µm is too thick and thus leads to unnecessary high material costs. Besides, the excessive thickness thickens the final light emitting device, and is against the prevailing trend toward microminiaturization.

After being formed, the thin layer is processed into a semi-cured state. In the present invention, the method for making the thin layer a semi-cured one may be any suitable technologies without limitation, and preferably baking. Particularly, the baking temperature is preferably performed for 1 to 4 hours at 65°C to 75°C so as to endow the fluorescent layer with acceptable shape-retaining ability and ability to deform under external force.

Optionally, before being baked, the thin layer may be put aside for a while or performs centrifugal treatment to let the fluorescent material deposit at the bottom of the thin layer. Alternatively, thin layers each having different concentrations of the fluorescent material or having different types of fluorescent materials may be stacked and baked together, so as to form a laminated semi-cured fluorescent layer.

After being formed, the semi-cured thin layer is cut into pieces of semi-cured fluorescent resin. The cutting may be performed in any manner without limitation. In addition, the present invention may include measuring color temperature of the cut pieces of semi-cured fluorescent resin, so as to sort the cut pieces by color temperature.

One specific example of the semi-cured fluorescent resin according to the present invention will be discussed below.

First, based on the weight of the final fluorescent resin, 19.12g of siloxane resin, 0.455g of toluene, 9.8g of yttrium aluminium garnet fluorescent material and 0.6g of a catalyst were put into a vacuum deaearation mixer for two-stage mixing so as to form a mixture. The first stage was performed for 3 minutes under 1 atm and at room temperature with a rotation rate of 800 rpm. The second stage lasted 30 seconds in a vacuum at room temperature, with a rotation rate of 1200 rpm. The mixture such formed was then applied to a platform by means of knife coating so as to form a thin layer with a thickness of 75µm. Afterward, the thin layer was baked for 2 hours in an oven of 70°C, so that the resin was partially cured and became B-stage/semi-cured fluorescent resin. The semi-cured fluorescent resin was at last cut into a predetermined size. A blue light emitting diode having a wavelength of 460 nm was used for measuring color temperature so as to sort the cut pieces of the semi-cured fluorescent resin by color temperature.

The following description is directed to the second through fourth embodiments of the present invention and stresses the manufacturing process and features of the disclosed light emitting device.

### «Second Embodiment»

After finalized as described above, the semi-cured fluorescent resin can be used to make the disclosed light emitting device. The process for making the light emitting device of the present invention is herein explained with reference to the accompanying drawings.

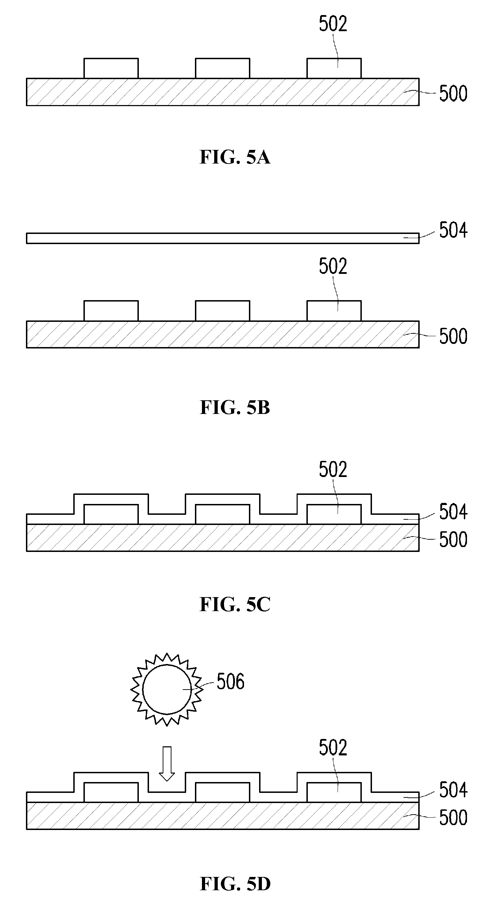

First, as shown in FIG. 5A, a carrier 500 is provided. The carrier 500 is selected as described previously. Particularly, where the light emitting device has a substrate, there is an electrically conductive pattern (not shown) in the substrate in addition to the metal leadframe. The electrically conductive pattern allows the LED chip 502 after packaged to have electrical connection with an external circuit. Where the light emitting device is built without a substrate, the carrier 500 of FIG. 5A may be any carrying body, and preferably one provided with release film. The release film facilitates removal of the carrier from the light emitting device after the last step, namely singulation. Afterward, the LED chip 502 is deposited on the carrier 500. Where the light emitting device has a substrate, the LED chip 502 may be permanently fixed to the carrier 500 using solder, die bond paste or similar materials. Where there is no substrate, the chip 502 can be temporarily fixed to the carrier 500 via release film or other less adhesive materials. In addition, where the LED chip 502 is a vertical chip or a horizontal chip, a conductive wire has to be connected to the electric pattern of the carrier 500, and this will be discussed later with a particular embodiment.

Then, semi-cured fluorescent resin 504 as made in the first embodiment is deposited to the carrier 500 having the LED chip 502, as shown in FIG. 5B.

After provision of the providing semi-cured fluorescent resin 504, laminating operation is performed, as shown in FIG. 5C. In the present invention, such laminating operation is thermal compressing performed in a vacuum environment, so as to conformally coat the semi-cured fluorescent resin 504 on the LED chip 502 and the carrier 500. The semi-cured fluorescent resin 504 is then further cured for enhancing mechanical strength. Preferably, in the laminating process, the laminating chamber is held at 100°C to 250°C and at the vacuum preferably 5pa to 40pa. Furthermore, when vacuumed, the laminating chamber may be preheated with temperature preferably smaller than 50°C.

Referring to FIG. 5D, the last step is singulation. This step involves subsequently or simultaneously cutting cured fluorescent resin 504 together with the carrier 500 into the fluorescent layer 304 and the substrate 300 in the light emitting device 30 of FIG. 3. The present invention puts no limitation to how singulation is performed, and tool cutting and laser cutting are both feasible ways. FIG. 5D exemplarily shows a tool 506 used for cutting.

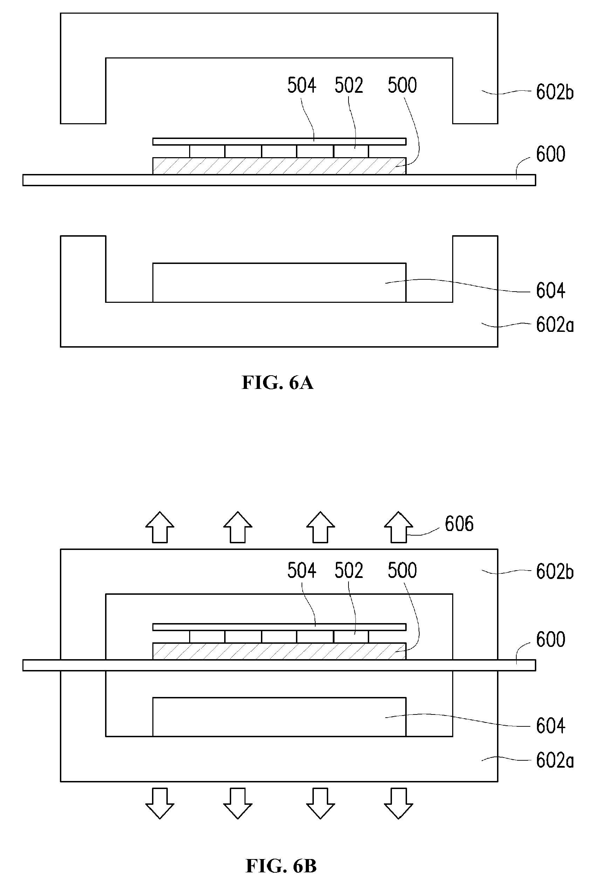

In the present invention, the laminating operation depicted in FIG. 5C may be performed as continuous, batch processing. The following description will be explained below with reference to FIG. 6A through FIG. 6D.

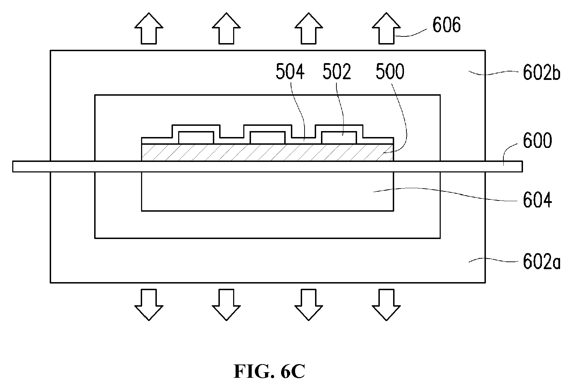

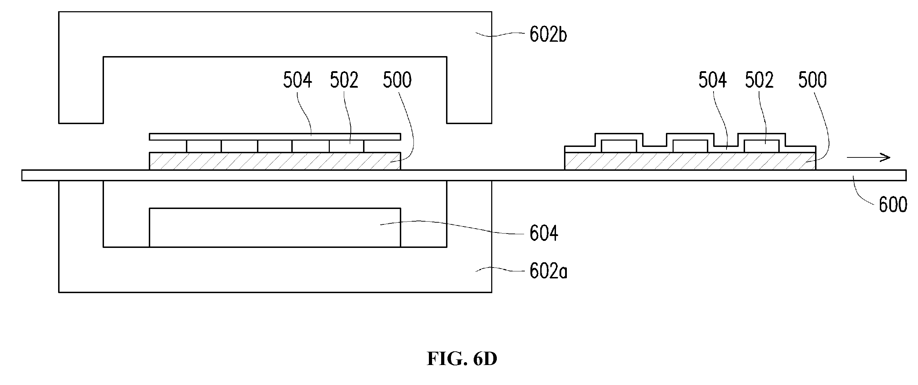

First, the carrier 500 carrying the chip 502 and the semi-cured fluorescent resin 504 are placed on a hot-compressing cushion 600 (made of PTFE or PET) and fed into the laminating chambers 602a, 602b (Step 1; FIG. 6A). The chambers 602a, 602b are then closed and vacuuming 606 is started (Step 2; FIG. 6B). Then the heating stage 604 is lifted and heated to 100°C to 250°C for thermal laminating (Step 3; FIG. 6C). At last, the laminating chambers 602a, 602b are opened for removal of the processed batch before the next batch of the carrier 500 carrying the LED chip 502 and the fluorescent resin 504 for thermal press bonding (FIG. 6D). With the described process, it is possible to perform laminating operation subsequently. Following the laminating step, atmospheric baking may be performed at preferably 120°C to 170°C, and more preferably 130°C to 160°C. In the present invention, baking may be performed using a gradient temperature-elevating method.

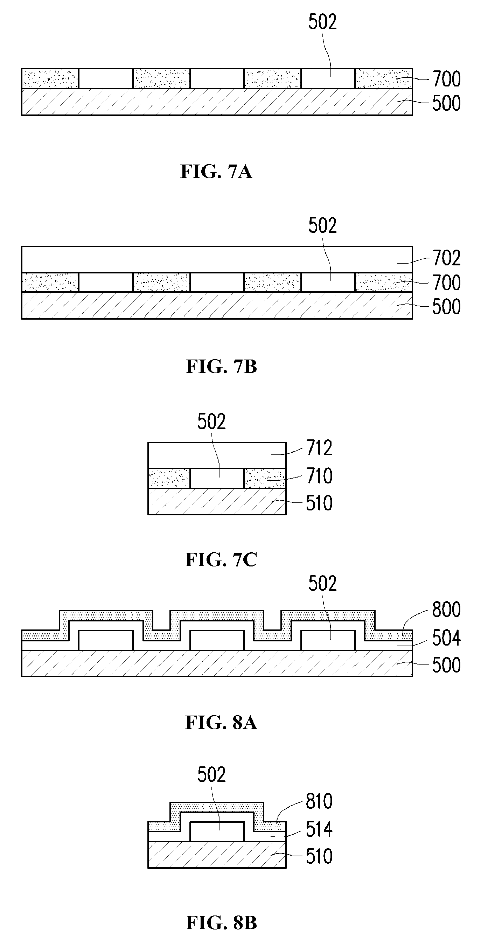

In some variant examples, the light emitting device comprises a reflective portion, and the fluorescent layer is coated on the reflective portion, as shown in FIG. 7A and FIG. 7B.

In particular, after the LED chip 502 is deposited in the step of FIG. 5A, the reflective material 700 is such formed on the carrier 500 at the parts not covered by the chip 502 and contacts the chip 502 (FIG. 7A). Subsequently, semi-cured fluorescent resin 702 is provided, followed by perfoming the lamination step (FIG. 7B) and the singulation step. The reflective material 700 may be cured before, after or at the same time as the semi-cured fluorescent resin 702 receives thermal compressing. Then during singulation, the cured fluorescent resin 702, the cured reflective material 700 and the carrier 500 are cut subsequently or simultaneously, so as to form the light emitting device (FIG. 7C). The light emitting device comprises a substrate 510, an LED chip 502 disposed on the substrate 510, a fluorescent layer 712 and a reflective portion 710. The reflective portion 710 surrounds lateral surface of the LED chip 502 and contacts the LED chip 502. The fluorescent layer 712 is at least partially and conformally coated on LED chip 502. Particularly, the reflective material 700 is cured and cut to form the reflective portion 710. The reflective portion 710 is level with the LED chip 502. However, the present invention is not limited to this configuration and the reflective portion 710 may be higher or lower than the LED chip 502. The fluorescent layer 712 may be conformally coated on the upper surface of the reflective portion. It is to be noted that what shown in FIG. 7C is one embodiment of the arrangement between the reflective portion and the LED chip, and the present invention is not limited to this configuration. Alternatively, the reflective portion may have no contact with the LED chip.

In some variant examples, the light emitting device comprises a translucent layer 810. The translucent layer 810 is conformally coated on the fluorescent layer 514, as shown in FIG. 8A and FIG. 8B.

Particularly, after the semi-cured fluorescent resin 504 is laminated in FIG. 5C, a layer of translucent resin 800 is provided on the semi-cured fluorescent resin 504 and laminating is performed once more. Alternatively, the semi-cured fluorescent resin 504 and the translucent resin 800 are stacked and backed in the step of making the thin layer, and then all of them are provided to the carrier 500 carrying the LED chip 502. Such operation forms a stacked structure as shown in FIG. 8A. In the singulation step, the cured translucent resin 800, the semi-cured fluorescent resin 504 and the carrier 500 are cut subsequently or simultaneously, so as to form a light emitting device having the translucent layer 810, the fluorescent layer 514, the substrate 510 and the LED chip 502.

In some variant examples not shown, multiple layers of semi-cured fluorescent resin are stacked to form multilayer fluorescent resin, and finally form stacked fluorescent layers. In this example, different layers of the semi-cured fluorescent resin may be arranged according to the concentrations of the fluorescent material therein so as to provide desired light emission pattern and color uniformity. For example, the layers with higher fluorescent material concentrations are arranged lower (closer to the LED chip after laminated), while those with lower fluorescent material concentrations are stacked thereon, so that the fluorescent material concentrations are reduced upward as the fluorescent resin/fluorescent resin layers are stacked. On the contrary, the layers of the semi-cured fluorescent resin having lower fluorescent material concentrations may be arranged lower, and those with higher fluorescent material concentrations may be put thereon in order, so that the material concentrations are increased upward as the layers are stacked. Additionally, In light of light conversion rate, the fluorescent resins with different fluorescent materials may be orderly stacked. For instance, the layers are such arranged that yellow/green fluorescent materials are close to the LED chip, and red fluorescent materials are arranged on the yellow/green fluorescent materials.

In the present invention, the translucent layer and the fluorescent layer are made of materials with different characteristics. Since the fluorescent layer directly covers the chip, the conductive wire and the substrate, it serves to not only keep the relative position of the three components, but also to some extent buffer the pressure generated when the translucent layer is applied. The translucent layer is subject to its optical and protective purposes, and may thus have its shape designed for better light diffusion. In particular, the translucent layer is usually made of a material having relatively high mechanical strength and relatively low moisture permeability and oxygen permeability. However, for the sake of tight combination and easy application, it may be made of the same basic resin as the fluorescent layer. In this case the translucent layer and the fluorescent layer are substantially the same.

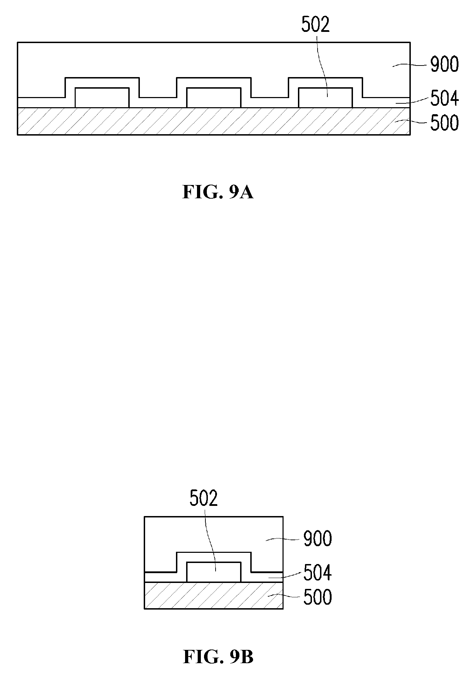

In this embodiment, the translucent layer is formed by laminated layers of semi-cured resin. However, in some variant examples, the translucent layer may be formed by means of molding, rotary coating, or knife coating so as to have an even upper surface, and its material may be resin of relative high rigidity, e.g. epoxy resin. Reference is now made to FIG. 9A and FIG. 9B. In FIG. 9A, the translucent layer 900 is made by molding epoxy resin to form a flat surface, as shown in FIG. 9A. Hence, after singulation, translucent layer 900 also has a flat surface as shown in FIG. 9B.

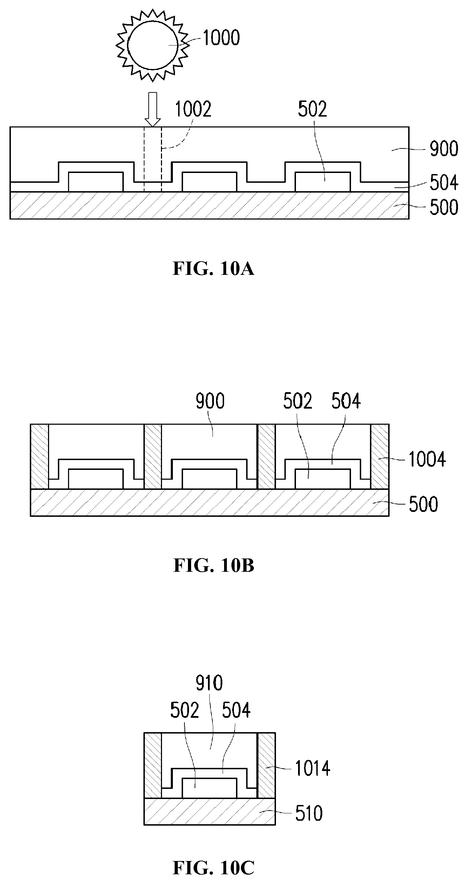

In some variant examples, the fluorescent layer and the translucent layer may have their lateral surface provided with reflective portions, as shown in FIG. 10A through FIG. 10C.

After the structure as shown in FIG. 9A is formed, a tool 1000 is used to cut the semi-cured fluorescent resin 504 and the translucent resin 900, so as to create grooves 1002, as shown in FIG. 10A. Then the grooves 1002 are filled with the reflective material 1004, as shown in FIG. 10B. Afterward, curing is performed as an optional step. At last, the reflective material 1004 and the carrier 500 are cut in a subsequent or simultaneous manner, thereby forming the light emitting device as shown in FIG. 10C. The light emitting device has the LED chip 502 deposited on the substrate 510, the fluorescent layer 514 conformally coated thereon, and the translucent layer 910 with a flat surface, while the reflective portions 1014 are formed at the opposite lateral surfaces of the fluorescent layer 514 and the opposite lateral surface of the translucent layer 910.

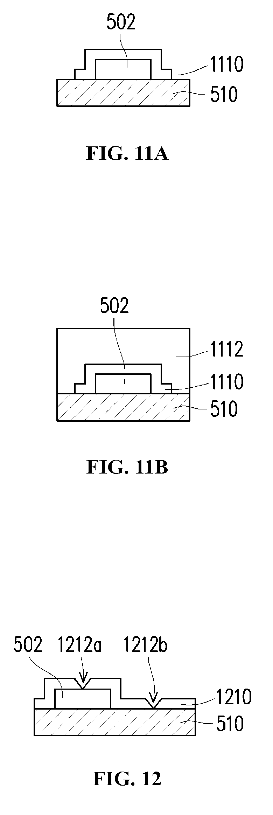

In the light emitting device as shown in FIG. 3, the fluorescent layer 304 extends to the edges of the substrate 510 and is level with the edges of the substrate 510. However, in some variant examples, the fluorescent layer does not extend to the edges of the substrate, as shown in FIG. 11A and FIG. 11B.

In the variant example shown in FIG. 11A, the fluorescent layer 1110 does not extend to edges to the substrate 510, so the surface of the substrate 510 is partially exposed. This reduces the risk that the fluorescent layer 1110 may be lifted at the edges of the substrate 510. Further, in the variant example shown in FIG. 11B, a translucent layer 1112 may be provided outside the fluorescent layer 1110. In this case the translucent layer 1112 fully covers the fluorescent layer 1110, so as to further enhance resistance of the fluorescent material 1110 to moisture and oxygen. In FIG. 11B, lateral surfaces of the translucent layer 1112 are level with lateral surface of the substrate 510. However, the present invention is not limited to this configuration, and the lateral surface of the translucent layer 1112 may be not level with that of the substrate 510.

The present invention has no limitation to the method that prevents the fluorescent layer from extending to the edges of the substrate. For example, the fluorescent layer may be precut after laminated in the step of FIG. 5C so that grooves are formed to expose parts of the carrier surface. Subsequently, as shown in FIG. 5D, singulation is performed on the carrier along these grooves. In another embodiment, after the singulation step as depicted in FIG. 5D, cutting is performed to single light emitting device for removing the parts of fluorescent layer that cover the edges of the substrate so as to expose the substrate surface at its edges. Alternatively, in the step of FIG. 5B, a precut semi-cured fluorescent resin is provided. The fluorescent resin is such precut that traces instead of grooves are formed thereon. Later, when the laminating step of FIG. 5C is performed, the fluorescent resin separates into pieces along the traces under stress. Thus, during later singulation, there is no need to cut the fluorescent layer performed, thereby eliminating the risk of separation between the fluorescent layer and the substrate.

In the present invention, while the fluorescent layer is conformally coated on the LED chip and the substrate, its thickness is unnecessarily uniform. In some variant examples, the fluorescent layer has a variable thickness, as shown in FIG. 12.

In the light emitting device as shown in FIG. 12, the fluorescent layer 1210 has v cuts 1212a, 1212b formed above the chip 502 and above the substrate 510, respectively, for providing varied light emitting effects. In particular, the present invention has no limitation to variation of thickness. For example, cuts or bulges of various shapes as local shape modifications may be formed in the fluorescent layer 1210. Alternatively, its surface may be locally roughened. In the present invention, the number and locations of the shape modifications may be adapted to practical needs. The present invention has no limitation to the method for forming these local shape modifications and any suitable approaches may be implemented. For example, a tool may be used to form cuts on the cured fluorescent layer. Alternatively, in the process of making the semi-cured fluorescent layer, the mixture is applied to a plane having a rough surface at the stage of formation of the thin layer, so that the formed semi-cured fluorescent layer has a corresponded rough surface.

In the present invention, for minimizing degradation of the fluorescent material, it is preferable to use a resin composition having its moisture permeability below 11 g/m²/24Hr and having its oxygen permeability below 400 cm³/m²/24Hr as the encapsulation resin (referred to the fluorescent layer and/or the translucent layer with the conformal process). Particularly, in the present invention, such encapsulation resin provides excellent protection to tetravalent-manganese-activated fluorescent materials. The following experiment is discussed for explaining the benefits of the encapsulation resin.

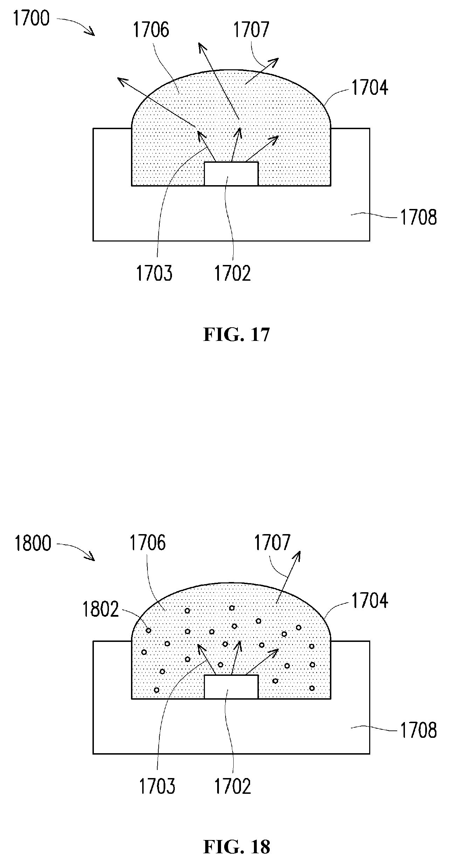

FIG. 17 shows an encapsulating experiment. The light emitting device 1700 includes a light emitting chip 1702, a dispensing resin 1704 and a red fluorescent material 1706. The dispensing resin 1704 covers the light emitting chip 1702, and the red fluorescent material 1706 is distributed within the encapsulation resin 1704. The red fluorescent material may be a tetravalent-manganese-activated fluorescent material, with its chemical structure as described previously. In the present embodiment, there is further a support 1708 for carrying the light emitting chip 1702, and the dispensing resin 1704 is applied thereon. The support 1708 may be formed with a structure different from that shown in FIG. 17 according to the actual design of the light emitting device. Particularly, a substrate/carrier as described previously may be used as the support and the resin composition having those characteristics as described previously may be used to form the fluorescent layer, so as to protect the tetravalent-manganese-activated fluorescent material mixed therein. However, the aforementioned resin composition may be used to form the translucent layer and applied to the fluorescent layer having the tetravalent-manganese-activated fluorescent material. This make the translucent layer have its moisture permeability and oxygen permeability smaller than or equal to those of the fluorescent layer, thereby endowing the translucent layer with equal or even better ability to prevent permeation or absorption of moisture/oxygen. In FIG. 17, the light emitting chip 1702 is configured to emit a first light beam 1703, which excites the red fluorescent material 1706 to emit a second light beam 1707.

In addition, in some variant examples, an oxynitride fluorescent material may be further added, as shown in FIG. 18. In the light emitting device 1800 of FIG. 18, apart from the LED chip 1702, the dispensing resin 1704 and the red fluorescent material 1706, there may be an oxynitride fluorescent material 1802 added into the dispensing resin 1704. The oxynitride fluorescent material 1802 has its chemical formula as that described previously.

In the present invention, the dispensing resin may be a phenyl siloxane resin composition or a methyl siloxane resin composition. The dispensing resin has its refractive index above for example 1.5, and preferably between 1.5 and 1.6. The dispensing resin may contain the foregoing fluorescent material, and may additionally contain a staining agent, a light diffusion agent, a filler and/or other additives.

A few experiments are discussed herein for demonstrating the benefits of resin compositions that have the characteristics defined in the present invention. However, the scope of the present invention shall not be limited thereto.

### Comparative Example 1

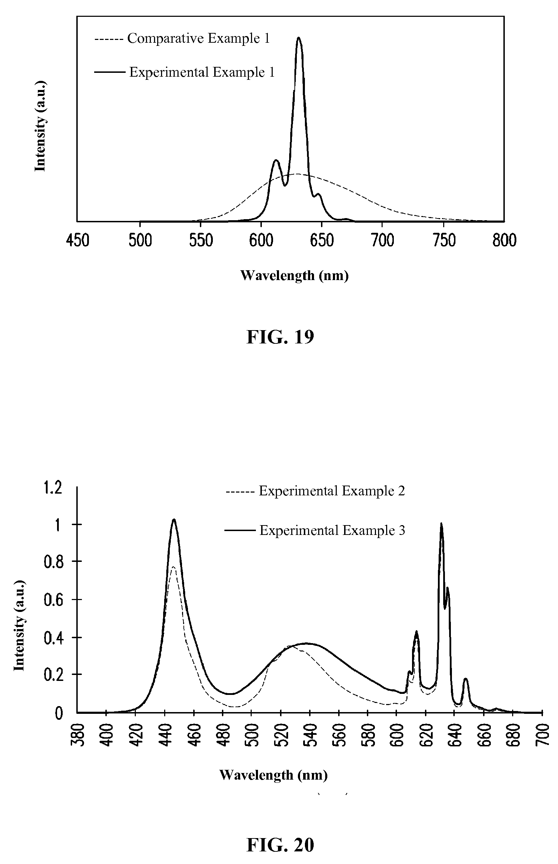

A 450 nm-light beam was selected to identify the emission spectrum of a red fluorescent material of CaAlSiN₃:Eu²⁺ (acquired from NEMOTO Company, Japan), and the result is shown in FIG. 19.

### Experimental Example 1

A 450 nm-light beam was selected to identify the emission spectrum of a red fluorescent material K₂Si_{0.95}F₆:Mn⁴⁺ 0.05 of the present invention, and the result is shown in FIG. 19.

As can be seen in FIG. 19, Comparative Example 1 has a wide emission spectrum extending to 750 nm. It emitted red light of low purity and low luminous intensity, which would in turn have adverse impact on luminous efficacy of white light. On the other hand, the red fluorescent material K₂Si_{0.95}F₆:Mn⁴⁺ _{0.05} compound of the present invention had its emission mainly within the range of 600nm∼650 nm, so it overcomes the defects of commercial red fluorescent materials.

### Experimental Example 2

(Si,Al)₆(O,N)₈:Eu²⁺ (acquired from DENKA Company Limited, Japan) and K₂Si_{0.95}F₆:Mn⁴⁺ _{0.05} were mixed at a weight ratio of 1.5: 1 and then such added into Encapsulation Resin A (with moisture permeability of 10.5 g/m²/24Hr; oxygen permeability of 382 cm³/m²/24Hr) that a ratio between the weight of the resin and the total weight of the powder came to 1: 1.2. The encapsulation resin contained the fluorescent material was then used to encapsulate an InGaN chip.

### Experimental Example 3

Sr₇(Si,Al)₁₂(O,N,C)₂₅: Eu²⁺ and K₂Si_{0.95}F₆:Mn⁴⁺_{0.05} were mixed at a weight ratio of 1: 1 and then such added into Encapsulation Resin A (phenyl-based silicone, moisture permeability of 10.5 g/m²/24Hr; oxygen permeability of 382 cm³/m²/24Hr) that a ratio between the weight of the resin and the total weight of the powder came to 1: 0.8. The encapsulation resin contained the fluorescent material was then used to encapsulate an InGaN chip.

Light-on tests (with a lighting current of 20mA) were performed on the light emitting devices made in Experimental Example 2 and Experimental Example 3, respectively, and the results are shown in Table 1 below, while the spectrums thereof are shown in FIG. 20.

**Table 1**

| | CIE-x | CIE-y | Φv(Im) | Efficiency% |
|---|---|---|---|---|
| Experimental Example 2 | 0.282 | 0.291 | 5.85 | 100.0% |
| Experimental Example 3 | 0.283 | 0.291 | 6.28 | 134.4% |

From Table 1 it is clear that with the same CIE-x and CIE-y, Experimental Example 2 exhibited 100% efficiency, yet Experimental Example 3 provided even higher efficiency that is 34% more as compared to Experimental Example 2. The increase of efficiency might be attributed to difference of chemical elements between the Sr₇(Si,Al)₁₂(O,N,C)₂₅: Eu²⁺ fluorescent material (containing (Sr,Ca,Ba) Al, Si, O, N, C, Eu) in Experimental Example 3 and Experimental Example 2.

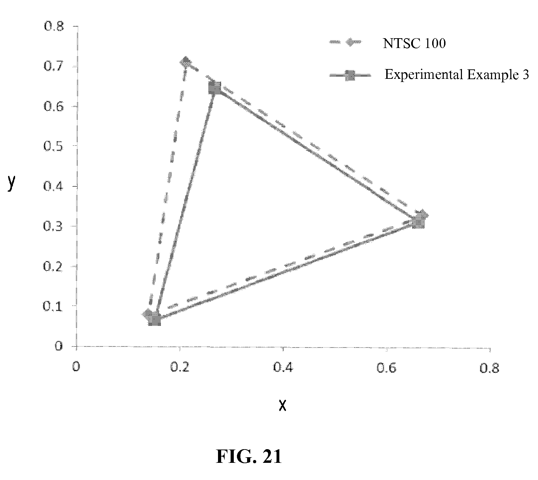

FIG. 21 is a chromaticity diagram of Experimental Example 3, the light after a color filter has an NTSC color gamut value of 84%.

### Comparative Example 2

Sr₇(Si,Al)₁₂(O,N,C)₂₅: Eu²⁺ and K₂Si_{0.95}F₆:Mn⁴⁺_{0.05} were mixed at a weight ratio of 1: 1 and then added into Encapsulation Resin B (phenyl-based silicone, having moisture permeability of 15 g/m²/24Hr and oxygen permeability of 726 cm³/m²/24Hr) so the weight of the resin and the total weight of the powder came to a ratio at 1: 0.8. The encapsulation resin contained the fluorescent material was then used to encapsulate an InGaN chip.

The light emitting devices obtained in Experimental Example 3 and in Comparative Example 2 were lit up at various conditions for performed endurance test, and the result are shown in Table 2 below.

**Table 2**

| Experiment No. | Term No. | 168 hrs | | | 500 hrs | | | 1000 hrs | | |
|---|---|---|---|---|---|---|---|---|---|---|
| | | ΔIV | ΔX | ΔY | IV | ΔX | ΔY | ΔIV | ΔX | ΔY |
| Experimental Example 3 | #1 | -4.74% | -0.008 | -0.007 | -5.03% | -0.011 | -0.007 | -6.54% | -0.013 | -0.007 |
| | #2 | -2.90% | -0.004 | -0.005 | -2.47% | -0.006 | -0.005 | -2.85% | -0.007 | -0.005 |
| | #3 | -3.80% | -0.007 | -0.005 | -3.74% | -0.010 | -0.006 | -4.88% | -0.013 | -0.006 |
| | #4 | -5.79% | -0.011 | -0.006 | -6.71% | -0.015 | -0.007 | -9.21% | -0.018 | -0.007 |
| Comparative Example 2 | #1 | -1.80% | -0.006 | -0.005 | -2.17% | -0.009 | -0.006 | -4.08% | -0.010 | -0.007 |
| | #2 | -0.25% | -0.003 | -0.003 | 0.03% | -0.004 | -0.004 | -0.87% | -0.004 | -0.003 |
| | #3 | -1.47% | -0.006 | -0.005 | -1.05% | -0.008 | -0.006 | -2.62% | -0.011 | -0.006 |
| | #4 | 3.30% | -0.001 | 0.001 | 3.16% | -0.003 | 0.000 | 1.48% | -0.004 | -0.001 |

| | | | | | | | | | | |
|---|---|---|---|---|---|---|---|---|---|---|
| Term #1: driving current of 150 mA, temperature of 60°C, relative humidity of 90%. Term #2: driving current of 150 mA, temperature of 25°C, in atmosphere. Term #3: driving current of 150 mA, temperature of 25°C, in atmosphere. Term #4: driving current of 45 mA, temperature of 85°C, in atmosphere. Δ IV: reduction in brightness as compared to initial brightness, expressed in percentage. Δ X: CIE X coordinate deviation from initial brightness. Δ Y: CIE Y coordinate deviation from initial brightness. | | | | | | | | | | |

In the endurance tests recorded in Table 2, the only difference between Experimental Example 3 and Comparative Example 2 relies on their moisture permeability and oxygen permeability. According to the results shown in Table 2, the light emitting device obtained in Experimental Example 3 under all the test terms exhibited less IV reduction and less CIE coordinate deviation as compared to the light emitting device obtained in Comparative Example 2. This demonstrates that the combination of the fluorescent materials of the present invention when working with resin having its moisture permeability below 10.5 g/m²/24Hr and having its oxygen permeability below 382 cm³/m²/24Hr can resist hydrolysis and degradation better.

To sum up, by using the red fluorescent material that has a chemical formula of A₂[MF₆]:Mn⁴⁺ with encapsulation resin possessing specific physical properties, the present invention can not only expand the color gamut of a TV backlight source, but also prevent the red fluorescent material from hydrolysis and degradation, thereby improving overall reliability of the disclosed light emitting device. In addition, according to the present invention, fluorescent materials of other colors may be used additionally to further expand the color gamut of a backlight source.

### «Third Embodiment»

The following description is directed to a case where the chip of the light emitting device requires wiring, namely the case where a horizontal chip or a vertical chip is used in the disclosed light emitting device. When a horizontal chip or vertical chip is used as the chip of the present invention, a conductive wire has to be provided to connect the upper surface of the chip with the circuit pattern of the substrate. In this case, a conventional approach of applying rigid resin onto the conductive wire is likely to break the wire. The present invention differently uses the semi-cured fluorescent resin as the precursor of the fluorescent layer, so the semi-cured fluorescent resin conforms its own shape to the conductive wire. Alternatively, the conductive wire may run through, so as to not break due to application of the resin. The cured fluorescent layer then serves as a buffer between the subsequently applied translucent layer or other external material and the conductive wire for absorbing stress so as to protect the conductive wire, or protect the connection between the chip and the electrodes.

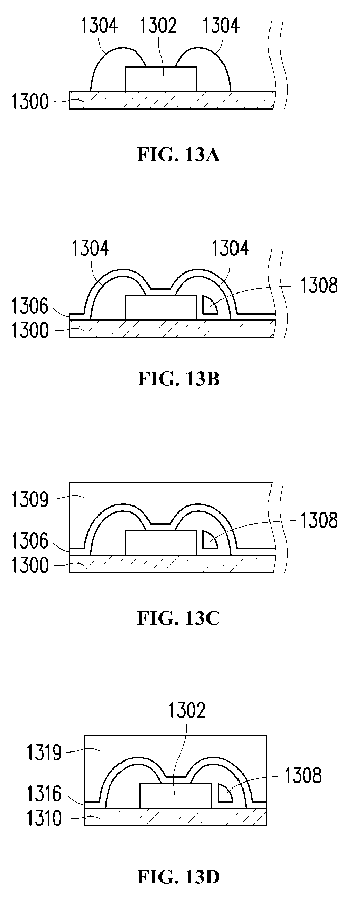

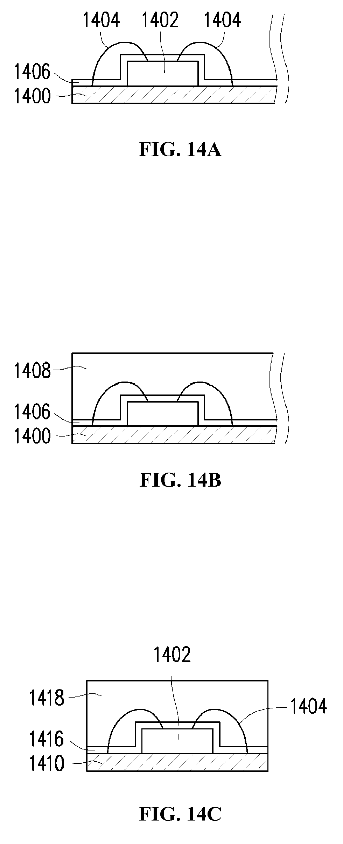

In this embodiment, the fluorescent layer is conformally coated on the conductive wire. A void portion may be formed below the conductive wire. The fluorescent layer flanks the conductive wire from two sides of the void portion. In another embodiment, no void portion is formed below the conductive wire, and thus the fluorescent layer can fully embrace conductive wire. Alternatively, the conductive wire has its highest point, or its apogee, passing through the fluorescent layer. In this case the ends of the conductive wire that are connected to the chip are embraced by the fluorescent layer. FIG. 13 and FIG. 14 are provided for illustrating various embodiments involving such conductive wire.

First, after the LED chip 1302 is deposited on the carrier 1300, wire bonding is performed to connect one end of at least one conductive wire 1304 with the upper surface of the LED chip 1302, and connect an opposite end of the conductive wire 1304 with a conductive pattern (not shown) of the carrier 1300, as shown in FIG. 13A.

Then, a semi-cured fluorescent resin 1306 is provided and laminating operation is performed. After lamination, the semi-cured fluorescent resin 1306 conformally covers the conductive wire 1304, meaning that in a top view of the assembly the semi-cured fluorescent resin 1306 flasks the conductive wire 1304 from two sides thereof. In some embodiments, a void portion may be formed below the conductive wire, as shown in FIG. 13B. The void portion 1308 below conductive wire 1304 acts as a stress buffer inside the light emitting device, for dealing with the bulk stress generated when the resin 1306 expands under heat. While in FIG. 13B there is only one conductive wire 1304 provided with such void portion 1308, it is apparent to people skilled in the art, by referring to the present invention, that such void portion 1308 may be formed below each of the conductive wires, and all these modifications shall be within the scope of the present invention.

Then, as an optional step, a translucent resin 1309 is applied onto the semi-cured fluorescent resin 1306 and cured, as shown in FIG. 13C. The translucent resin 1309 is preferably a rigid resin layer, such as epoxy resin. At last, singulation is performed to subsequently or simultaneously cut the cured translucent resin 1309, the fluorescent resin 1306 and the carrier 1300, thereby forming the light emitting device as shown in FIG. 13D. On the substrate 1310, the translucent layer 1319 covers the fluorescent layer 1316, and the fluorescent layer 1316 conformally covers the conductive wire 1304, while the void portion 1308 is formed below the conductive wire 1304. While FIG. 13D depicts a light emitting device having the void portion 1308, the present invention in some embodiments however has no such void portion and is so made that the fluorescent layer fully embraces the conductive wire. In addition, reflective portions as shown in FIG. 10C may be added to improve light convergence.

In some variant examples, the conductive wire may pass through the fluorescent layer. Particularly, the conductive wire has its highest point, or its apogee, passing through the fluorescent layer, and the two ends of the conductive wire that are connected to the LED chip and the light emitting device, respectively, may be embraced by the fluorescent layer, as shown in FIG. 14A through FIG. 14C.

After the wire bonding step as shown in FIG. 13A is performed, a semi-cured fluorescent resin 1406 is provided and laminating operation is performed. After lamination, the conductive wire 1404 runs through the semi-cured fluorescent resin 1406, meaning that in a lateral view of the assembly the semi-cured fluorescent resin 1406 is conformally coated on the surface of the LED chip 1402 and embrace both the two ends of the conductive wire 1404, as shown in FIG. 14A. As an optional step, a translucent resin 1408 is provided on the semi-cured fluorescent resin 1406 before curing is performed, as shown in FIG. 14B. The resin 1408 is preferably a rigid one, e.g. epoxide. At last, singulation is performed by subsequently or simultaneously cutting the cured translucent layer 1418 and the substrate 1410, so as to form the light emitting device as shown in FIG. 14C. In one embodiment, the conductive wire 1404 runs through the fluorescent layer 1416, and has parts, namely two ends thereof, covered by the fluorescent layer 1416. In addition, reflective portions as shown in FIG. 10C may be added to improve light concentration.

In some other variant examples not shown, a wired chip may be used in the embodiment as shown in FIG. 7B. In this case, the reflective portion and the light emitting diode chip are level with each other, or the reflective portion is higher than the LED chip while the fluorescent layer is coated on the reflective portion. The light emitting device further includes at least one conductive wire for connecting the LED chip with the electrodes in the light emitting device. The fluorescent layer embraces a part of the conductive wire, and the reflective portion embraces another part of the conductive wire.

### «Fourth Embodiment»

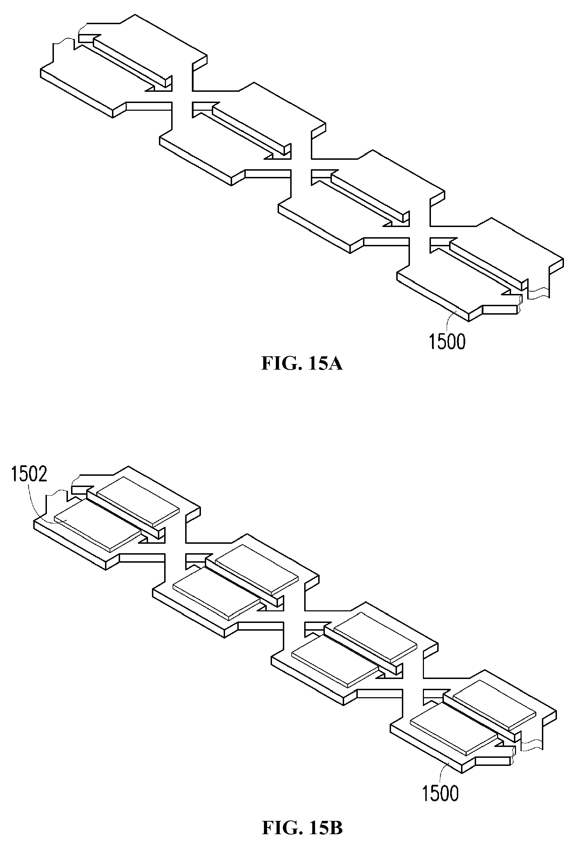

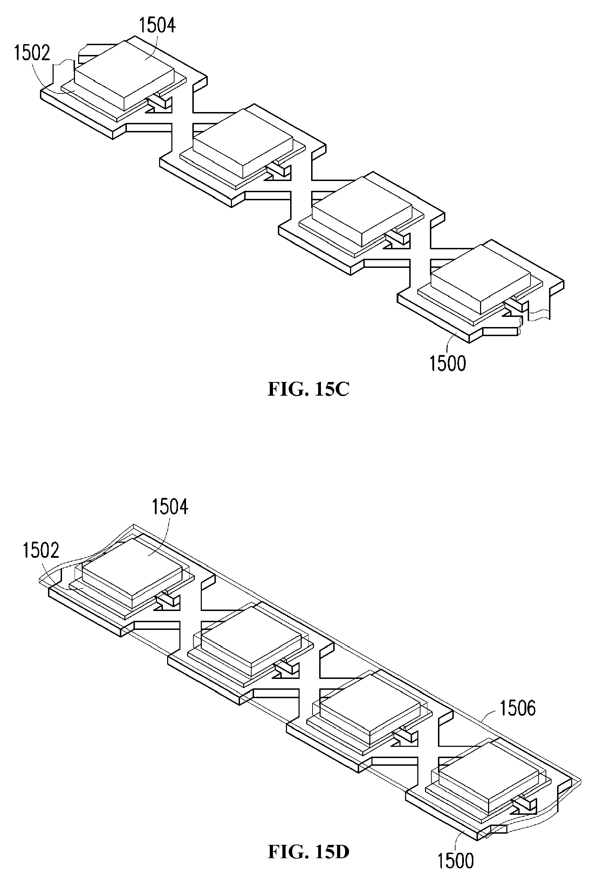

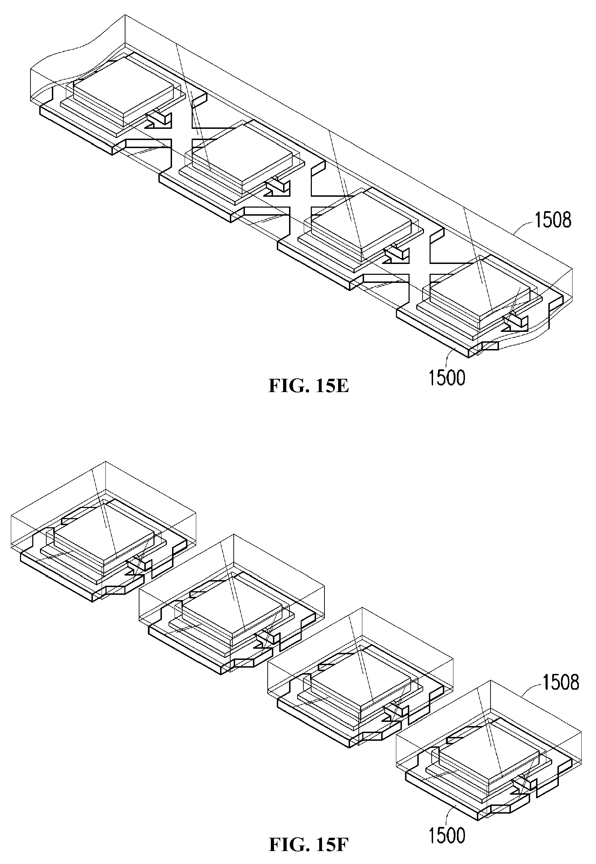

A light emitting device made using anisotropic conductive adhesive (ACA) and a molding process according to the present invention is now discussed. Reference is first made to FIG. 15 for the discussed manufacturing process. It is to be noted that while the metal leadframe is herein used as the carrier/substrate, implementation of the present invention is not limited thereto, and a PCBs or other materials may be used instead.

In Step 1, a metal leadframe 1500 is provided on the release film, wherein the lateral surfaces of the metal leadframe 1500 may partially or fully embedded in the release film (FIG. 15A).

In Step 2, ACA 1502 is deposited on the metal leadframe 1500 (FIG. 15B).

In Step 3, the ACA 1502 fixes the LED chip 1504 to the metal leadframe 1500 (FIG. 15C).

In Step 4, semi-cured fluorescent resin 1506 that can be placed on the surface of the LED chip 1504 is provided as a conformal pattern. The semi-cured fluorescent resin 1506 may extend to cover the lateral surface of the ACA 1502 and the lateral surface of the metal leadframe 1500 if necessary (FIG. 15D). Additionally, the semi-cured fluorescent resin 1506 contains the fluorescent material.

In Step 5, translucent resin 1508 is provided on the semi-cured fluorescent resin 1506 (FIG. 15E).

In Step 6, singulation is performed to form a plurality of light emitting devices (FIG. 15F).

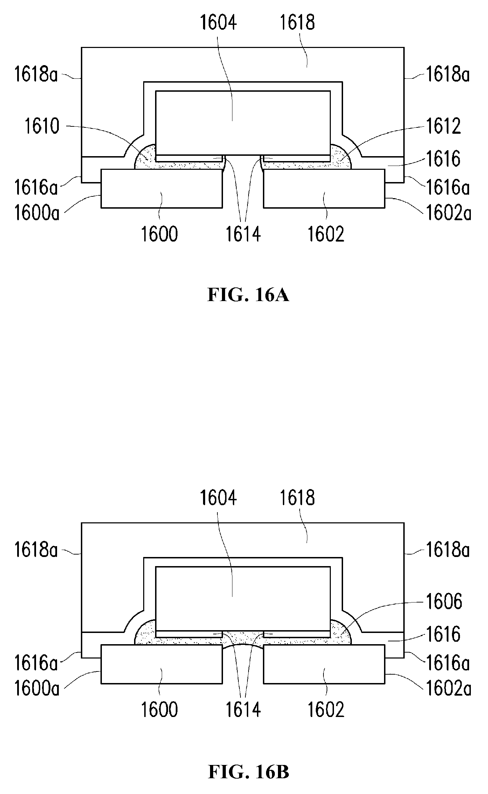

Through the steps given above, a light emitting device as shown in FIG. 16A is made. The light emitting device comprises a substrate that includes a pair of electrode pads 1600, 1602, preferably the substrate is constructed from a pair of electrode pads; an LED chip 1604, the fluorescent layer 1616, the translucent layer 1618 and the anisotropic conductive adhesive (ACA) 1610, 1612. The LED chip 1604 is exemplarily a flip chip and is bonded to the electrode pads 1600, 1602 by means of die bonding. That is the LED chip 1604 is directly electrically connected to the electrode pads 1600, 1602, without using conductive wire. The ACA 1610 on the electrode pad 1600 and the ACA 1612 on the electrode pad 1602 are separated from each other. The fluorescent layer 1616 conformally covers the LED chip 1604, the ACA 1610, 1612 and the electrode pads 1600, 1602, and extends to cover parts of the lateral surface 1600a, 1602a of the electrode pads 1600, 1602. The translucent layer 1618 covers the fluorescent layer 1616, with its lateral surface 1618a level with the lateral surface 1616a of the fluorescent layer 1616. In the present embodiment, the metal leadframe is not fully embedded in the release film (not shown), but only has parts of the electrode pads 1600, 1602 embedded. Thus, parts of the electrode pads 1600, 1602 are covered by the release film, while the other parts are covered by the fluorescent layer 1616. After removal of the release film, the parts previously covered by the release film are exposed and free from the fluorescent layer 1616 and the translucent layer 1618. This causes a stepped structure at the lateral of the light emitting device. In other words, the lateral surface 1616a of the fluorescent layer 1616 and the lateral surface 1618a of the translucent layer 1618 are not level with lateral surface 1600a, 1602a of the electrode pads 1600, 1602.

In some variant examples, as shown in FIG. 16B, ACA 1606 continues to cover both the P-type electrode pad 1600 and the N-type electrode pad 1602, thereby reflecting light at the bottom of the chip 1604 well without the risk of short circuit. It is to be noted that because of the characteristics of ACA, although the ACA 1606 in this variant example is in a continuous form, electric conduction is limited to the regions between the electrodes 1614 of the chip 1604 and the electrode pads 1600, 1602 and anywhere else remains electric insulation. This secures the light emitting device from short circuit.

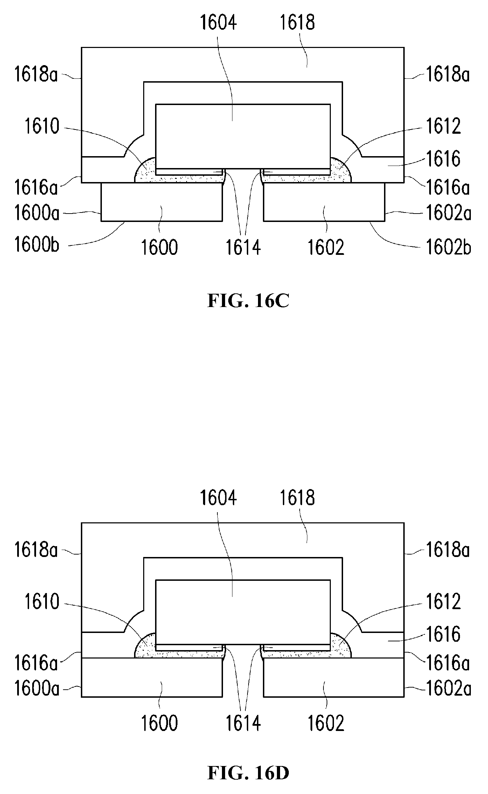

In some variant examples, different form the light emitting device of FIG. 16A, the electrode pads 1600, 1602 are fully embedded into the release film. Thus, after removal of the release film, the lateral surface 1600a and the bottom 1600b of the electrode pad 1600 and the lateral 1602a and the bottom 1602b of the electrode pad 1602 are fully exposed outside the fluorescent layer 1616 and the translucent layer 1618. Furthermore the fluorescent layer 1616 extends over the electrode pads 1602 and 1612, as shown in FIG. 16C. In addition, is the present variant example, ACA 1610, 1612 may be of any structure without limitation, and may be what shown in FIG. 16A or FIG. 16B.

In some variant examples, the lateral surface 1600a, 1602a of the electrode pads 1600, 1602 are level with the lateral surface 1616a of the fluorescent layer 1616 and the lateral 1618a of the translucent layer 1618, respectively, as shown in FIG. 16D.

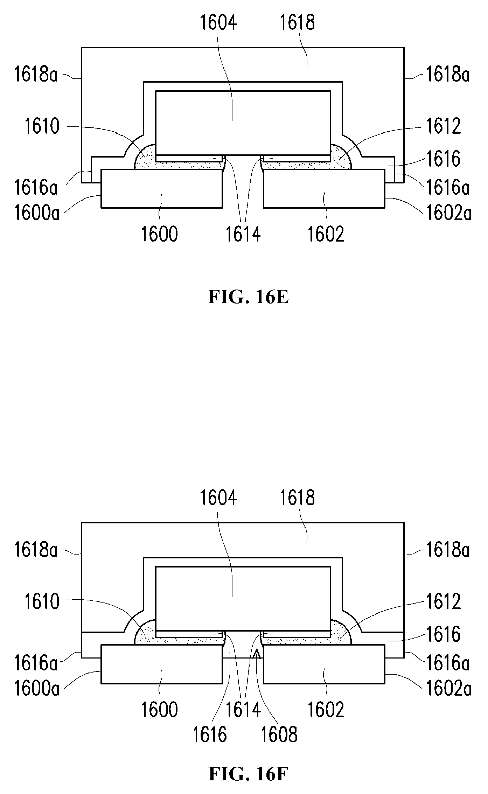

Since the fluorescent layer 1616 contains the fluorescent material, if the translucent layer 1618 and the fluorescent layer 1616 have their lateral surfaces level with each other, some converted light would be directly emitted from the lateral surface of the fluorescent layer 1616, leading to inconsistent light color. For addressing this problem, in some variant examples, the translucent layer 1618 extends to cover the lateral surface 1616a of the fluorescent layer 1616 and is not level with the bottoms of the electrode pads 1600, 1602, as shown in FIG. 16E.

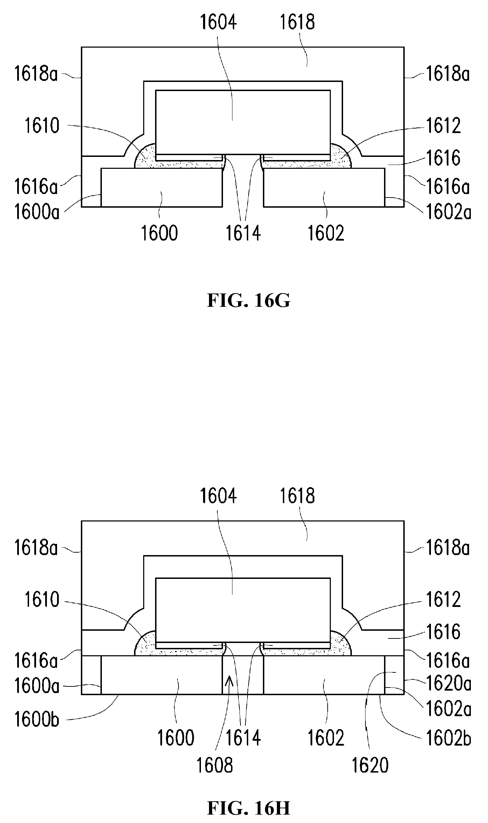

In some variant examples, for maintaining proper mechanical strength between the LED chip and the electrodes, especially in a case where the electrode pads 1600, 1602 are thinner than the chip 1064, the fluorescent layer 1616 may extend into the space 1608 between the P-type electrode pad 1600 and the N-type electrode pad 1602, as shown in FIG. 16F. Alternatively, as shown in FIG. 16G, the fluorescent layer 1616 may extend to entirely cover the lateral surface 1600a, 1602a of the electrode pads 1600, 1602. Additional application of the resin thus helps to enhance the mechanical strength of the light emitting device. Hence, where the semi-cured fluorescent layer 1616 is used, external force may be used to make the fluorescent layer 1616 enter the space between the electrode pads 1600, 1602 or extend to cover the electrode pads 1600, 1602, so that after cured the fluorescent layer contributes to improve the mechanical strength of the light emitting device and protect the ACA 1610, 1612.

As an approach to improving the mechanical strength of the carrier /substrate in addition to the foregoing variant examples, a space filler 1620 may be provided at the lateral surface 1600a, 1602a of the electrode pads 1600, 1602 and filled into the space 1608. Referring to FIG. 16H, the lateral surface 1600a, 1602a and the space 1608 all have the space filler 1620 therewith. The lateral surface 1616a of the fluorescent layer 1616 and the lateral surface 1618a of the translucent layer 1618 are level with the lateral surface 1620a of the space filler 1620.

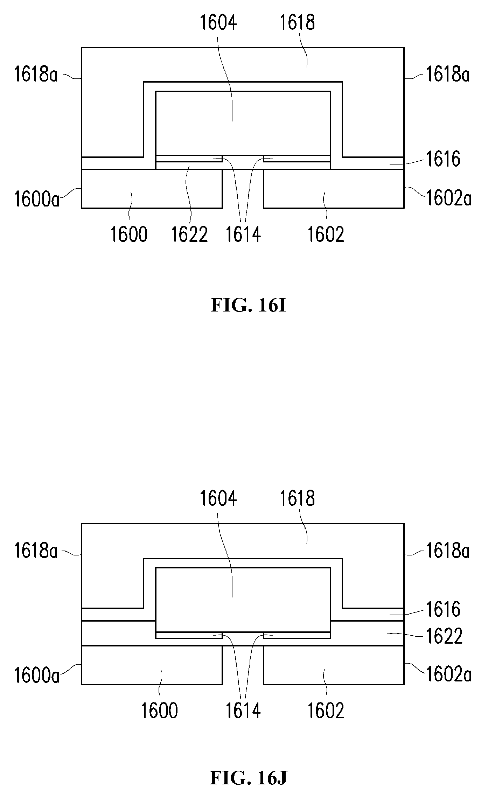

In some variant examples, it is possible to use anisotropic conductive film (ACF) instead of ACA, thereby further improving mechanical strength of the light emitting device and preventing the LED chip from coming off the electrode pads. In particular, the ACF 1622 may be formed in various ways, such as printing or coating. The ACF 1622 may comprise the reflective particles named above for better reflectivity. Where the applied area of the ACF 1622 is greater than the combined area of the LED chip 1604 and the electrode pads 1600, 1602, light extraction efficiency is further enhanced. In addition, it is poosible to apply ACF onto a wafer directly, so that the ACF 1622 is directly formed on the electrode 1614 of the chip 1604. Thereby, the process of applying ACF to the electrically conductive leadframe during packaging operation can be omitted. The area of the ACF 1622 mat be of the same size as the area of the electrode 1614 of the chip 1604, as shown in FIG. 16I. However, for simplifying operation, the area of the ACF 1622 may be slightly greater than that of the electrode 1614 of the chip 1604, or even equal to the area of the electrode pads 1600, 1602, as shown in FIG. 16J. In the latter case, the lateral surface of the ACF 1622 are level with lateral surfaces of the light emitting layer 1618, the fluorescent layer 1616 and the electrode pads 1600, 1602. In addition, ACF is unnecessarily consistent with that of the P-type electrode pad or the N-type electrode pad (e.g. being square), and may be of any shape as long as it provides enough combining area.

It is to be noted that while the light emitting device as shown in FIG. 16A through FIG. 16J uses ACA, it may use ACF instead of ACA and has the same appearance and form.

Further, a method for manufacturing a light emitting device using ACF comprises the following steps:
Step 1: providing a metal sheet;
Step 2: bonding LED chip to the metal sheet using ACF;
Step 3: providing a cover sheet to be placed on a surface of the LED chip as a conformal pattern;
Step 4: providing a resin for transfer moulding on the cover sheet; and
Step 5: performing singulation, so as to form a plurality of light emitting devices.

While the exemplary process described previously relates to use of a chip already having ACF (Step 2), it is apparent to people with ordinary skill in the art that the present invention is not limited thereto. Optionally, the ACF may be applied to the electrode pad/support before die bonding is performed thereon for the LED chip.

The present invention has been described with reference to the preferred embodiments and it is understood that the embodiments are not intended to limit the scope of the present invention. Moreover, as the contents disclosed herein should be readily understood and can be implemented by a person skilled in the art, all equivalent changes or modifications which do not depart from the concept of the present invention should be encompassed by the appended claims.

## Claims

1. A light emitting device, comprising:
a substrate;
an LED chip, disposed on the substrate; and
a fluorescent layer;
wherein the fluorescent layer is at least partially and conformally coated on the LED chip and the substrate.

2. The light emitting device of claim 1, wherein the substrate is constructed from a pair of electrode pads, and the electrode pads are separated by a space.

3. The light emitting device of claim 2, wherein a space filler is filled in the space.

4. The light emitting device of claim 2, wherein a space filler is provided at lateral surfaces of the electrode pads.

5. The light emitting device of claim 4, wherein lateral surfaces of the fluorescent layer are level with lateral surfaces of the space filler.

6. The light emitting device of claim 2, wherein the fluorescent layer is filled into the space.

7. The light emitting device of claim 2, wherein the fluorescent layer covers lateral surfaces of the electrode pads.

8. The light emitting device of claim 1, further comprising a translucent layer, which is conformally coated on the fluorescent layer.

9. The light emitting device of claim 8, wherein lateral surfaces of the translucent layer are level with lateral surfaces of the fluorescent layer.

10. The light emitting device of claim 8, wherein the translucent layer has moisture permeability and oxygen permeability that is equal to or lower than moisture permeability and oxygen permeability of the fluorescent layer.

11. The light emitting device of claim 1, further comprising a reflective portion, which surrounds the LED chip.

12. The light emitting device of claim 11, wherein the reflective portion contacts the LED chip.

13. The light emitting device of claim 1, further comprising a conductive wire, which connects the LED chip and the substrate.

14. The light emitting device of claim 13, wherein the fluorescent layer is conformally coated on the conductive wire.

15. The light emitting device of claim 14, wherein a void portion is formed below the conductive wire.
